# EUROPÄISCHE PATENTSCHRIFT

(11) **EP 3 515 157 B1**
(45) Veröffentlichungstag und Bekanntmachung des Hinweises auf die Patenterteilung: **22.12.2021**
(21) Anmeldenummer: 19152125.1
(22) Anmeldetag: 16.01.2019
(51) Int. Cl.: H05K 1/18, H05K 1/03, H05K 3/32, H05K 3/38, H05K 1/11, H05K 1/14, H05K 3/46

(54) **FLEXIBLE ELEKTRISCHE SCHALTUNG MIT VERBINDUNG ZWISCHEN ELEKTRISCH LEITFÄHIGEN STRUKTURELEMENTEN**
FLEXIBLE ELECTRICAL CIRCUIT WITH CONNECTION BETWEEN ELECTRICALLY CONDUCTIVE STRUCTURAL ELEMENTS
CIRCUIT ÉLECTRIQUE FLEXIBLE POURVU DE RACCORDEMENT ENTRE LES ÉLÉMENTS STRUCTURAUX ÉLECTRIQUEMENT CONDUCTEURS

(30) Priorität: 18.01.2018 DE 102018101101; 07.02.2018 DE 102018102734
(43) Veröffentlichungstag der Anmeldung: 24.07.2019
(73) Patentinhaber: Schreiner Group GmbH & Co. KG, 85764 Oberschleissheim (DE)
(72) Erfinder: Kalio, André, 85579 Neubiberg (DE); Häußler, Michael, 80992 München (DE); Mechtler, Christian, 81377 München (DE)
(74) Vertreter: Epping - Hermann - Fischer

(56) Entgegenhaltungen:
- DE-A1-102009 018 285
- DE-A1-102015 113 928
- DE-U1-202014 103 821
- US-A1- 2013 135 838

## Beschreibung

Die Erfindung betrifft eine flexible elektrische Schaltung mit einer Verbindung zwischen elektrisch leitfähigen Strukturelementen, insbesondere zwischen einer elektrischen Leiterbahn, die auf einem Trägermaterial angeordnet ist, und einer elektrisch leitenden Kontaktschicht, die auf der Unterseite einer elektrischen Komponente oder auf der Unterseite einer Trägerschicht, beispielsweise einer flexiblen Leiterplatte, angeordnet ist.

Eine flexible elektrische Schaltung lässt sich mittels einer Kleberschicht, die an einer Unterseite der flexiblen elektrischen Schaltung angeordnet ist, auf einfache Weise auf einen Körper, beispielsweise auf eine Medikamentenverpackung, aufbringen. Die flexible elektrische Schaltung kann ein Trägermaterial, beispielsweise eine Lackschicht, aufweisen, auf der eine elektrische Leiterbahn angeordnet ist. Die flexible elektrische Schaltung umfasst des Weiteren elektrische Komponenten, die mit der Leiterbahn elektrisch als auch mechanisch verbunden werden müssen.

Bei einer möglichen Ausführungsform der flexiblen elektrischen Schaltung muss eine elektrische Komponente beziehungsweise eine elektrisch leitende Kontaktschicht (Pad), die an der Unterseite der elektrischen Komponente angeordnet ist und dazu dient, elektrische Signale von der elektrischen Leiterbahn über die elektrisch leitenden Kontaktschicht zu der elektrischen Komponente zu übertragen, mit der Leiterbahn elektrisch und mechanisch verbunden werden. Des Weiteren muss die elektrische Komponente an den restlichen Trägermaterialien, insbesondere der mindestens einen Lackschicht, der flexiblen elektrischen Schaltung mechanisch fixiert werden.

Bei einer anderen Ausführungsform einer flexiblen elektrischen Schaltung sind die elektrischen Komponenten auf einer Trägerschicht, zum Beispiel einer flexiblen Leiterplatte, angeordnet. Auf der Rückseite der Trägerschicht können elektrisch leitende Kontaktflächen vorgesehen sein, die elektrisch mit den elektrischen Komponenten auf der Oberseite der Trägerschicht verbunden sind. In diesem Fall müssen die elektrisch leitenden Kontaktschichten auf der Unterseite der Trägerschicht mit der mindestens einen elektrischen Leiterbahn elektrisch und mechanisch verbunden werden. Des Weiteren muss die Trägerschicht an den restlichen Trägermaterialien, insbesondere der mindestens einen Lackschicht, der flexiblen Schaltung mechanisch fixiert werden.

Eine derartige flexible elektrische Schaltung kann auf einfache Weise in eine weitere elektrische Schaltung oder einen Gegenstand, zum Beispiel eine Verpackung, insbesondere eine Medikamentenverpackung, integriert werden, indem die flexible elektrische Schaltung mit ihrer Klebeschicht beispielsweise auf eine Platine der weiteren elektrischen Schaltung oder auf dem Gegenstand, beispielsweise der Verpackung, aufgeklebt wird.

Bei einer solchen flexiblen elektrischen Schaltung ist die Verbindung zwischen den elektrisch leitfähigen Strukturelementen, insbesondere zwischen den elektrischen Leiterbahnen und den elektrisch leitenden Kontaktschichten zur Kontaktierung der elektrischen Komponenten eine Schwachstelle, an der die flexible elektrische Schaltung auf leichte Weise beschädigt werden kann, sodass die elektrische Funktionalität nicht mehr gegeben ist.

DE 10 2015 113928 A1 offenbart eine flexible elektrische Schaltung gemäß dem Oberbegriff des Anspruchs 1.

DE 10 2009 018285 A1 offenbart eine Blisterverpackung , die eine Entnahmekontrolle erlaubt.

Ein Anliegen der vorliegenden Erfindung ist es, eine flexible elektrische Schaltung mit einer sicheren Verbindung zwischen elektrisch leitfähigen Strukturelementen anzugeben. Eine Ausführungsform einer solchen flexiblen elektrischen Schaltung mit einer sicheren und zuverlässigen Verbindung zwischen elektrisch leitfähigen Strukturelementen der flexiblen elektrischen Schaltung ist im Patentanspruch 1 angegeben.

Die flexible elektrische Schaltung umfasst mindestens eine Lackschicht, mindestens eine elektrische Leiterbahn, die über der mindestens einen Lackschicht angeordnet ist, mindestens eine elektrische Komponente und mindestens eine elektrisch leitende Kontaktschicht zur Kontaktierung der mindestens einen elektrischen Komponente. Des Weiteren umfasst die flexible elektrische Schaltung eine Leitkleberschicht und eine Schicht aus einem Haftvermittler. Die Schicht aus dem Haftvermittler ist auf der mindestens einen Lackschicht angeordnet. Die Leiterkleberschicht ist unter der mindestens einen elektrisch leitenden Kontaktschicht und über der Schicht aus dem Haftvermittler angeordnet.

Bei der erfindungsgemäßen flexiblen elektrischen Schaltung ist zwischen der mindestens einen Lackschicht und der Leitkleberschicht die Schicht aus dem Haftvermittler angeordnet. Die Leitkleberschicht ist zwischen der mindestens einen elektrisch leitenden Kontaktschicht und der Schicht aus dem Haftvermittler angeordnet.

Bei einer möglichen Ausführungsform ist die mindestens eine elektrische Komponente unmittelbar auf der Leitkleberschicht angeordnet. Bei dieser Ausführungsform ist die mindestens eine elektrische Komponente mittels der Leitkleberschicht und der Schicht aus dem Haftvermittler mechanisch an der mindestens einen Lackschicht fixiert. Durch die Schicht aus dem Haftvermittler haftet die mindestens eine elektrische Komponente mit Hilfe der Leitkleberschicht sicher auf der mindestens einen Lackschicht. Die Schicht aus dem Haftvermittler ermöglicht eine hohe mechanische Haftung zwischen der mindestens einen Lackschicht und der Leitkleberschicht beziehungsweise der mindestens einen elektrischen Komponente.

Bei einer anderen Ausführungsform ist die mindestens eine elektrische Komponente auf einer Trägerschicht angeordnet. Bei dieser Ausführungsform ist die Trägerschicht mittels der Leitkleberschicht auf der Schicht aus dem Haftvermittler aufgeklebt. Die Trägerschicht ist somit mittels der Leitkleberschicht und der Schicht aus dem Haftvermittler mechanisch an der mindestens einen Lackschicht befestigt. Die Trägerschicht kann zum Beispiel eine flexible Folie, eine flexible Leiterplatte oder eine starre Leiterplatte sein. Die mindestens eine elektrische Komponente kann auf der Oberseite oder der Unterseite oder auf beiden Seiten der Trägerschicht angeordnet sein. Die mindestens eine elektrisch leitende Kontaktschicht kann auf der Unterseite der Trägerschicht angeordnet sein. Durch die Schicht aus dem Haftvermittler haftet die Trägerschicht mit Hilfe der Leitkleberschicht sicher auf der mindestens einen Lackschicht. Die Schicht aus dem Haftvermittler ermöglicht eine hohe mechanische Haftung zwischen der mindestens einen Lackschicht und der Leitkleberschicht beziehungsweise der Trägerschicht.

Die flexible elektrische Schaltung weist beim Einwirken mechanischer Kräfte auf die Verbindungsstelle zwischen der mindestens einen Lackschicht und der mindestens einen elektrischen Komponente beziehungsweise der Trägerschicht eine geringe Ausfallrate auf, da die mindestens eine elektrische Komponente beziehungsweise die Trägerschicht insbesondere durch das Vorsehen der Schicht aus dem Haftvermittler fest auf der mindestens einen Lackschicht anhaftet. Die flexible elektrische Schaltungsanordnung aus der mindestens einen Lackschicht, der Schicht aus dem Haftvermittler, die auf der mindestens einen Lackschicht aufgetragen ist, der Leitkleberschicht, die als Verbindungsschicht zu der mindestens einen elektrisch leitenden Kontaktschicht oder zu der mindestens einen elektrischen Komponente oder zu der Trägerschicht dient, weist eine höhere Haftungskraft auf, als wenn die Leitkleberschicht unmittelbar auf die mindestens eine Lackschicht aufgetragen würde und kein Haftvermittler vorgesehen wäre. In Folge dessen besteht auch zwischen der mindestens einen elektrisch leitenden Kontaktschicht und der elektrischen Leiterbahn eine zuverlässige elektrische als auch mechanische Verbindung.

Die flexible elektrische Schaltung kann Teil einer Sensoranordnung sein. Eine derartige Sensoranordnung umfasst eine flexible elektrische Schaltung nach einer der oben genannten Ausführungsformen und ein Substrat. Die flexible elektrische Schaltung kann mittels einer Kleberschicht, die an der Unterseite der flexiblen elektrischen Schaltung angeordnet ist, auf das Substrat aufgeklebt sein. Das Substrat kann eine Verpackung, insbesondere eine Medikamentenverpackung, sein.

Die Erfindung wird im Folgenden anhand von Figuren, die Ausführungsformen der vorliegenden Erfindung zeigen, näher erläutert.

Es zeigen:
Figur 1 eine erste Ausführungsform einer Schichtanordnung mit elektrischen Leiterbahnen,
Figur 2 eine erste Ausführungsform einer flexiblen elektrischen Schaltung mit Verbindung zwischen elektrisch leitfähigen Strukturelementen,
Figur 3 eine zweite, verbesserte Ausführungsform einer Schichtanordnung mit elektrischen Leiterbahnen,
Figur 4A eine zweite, verbesserte Ausführungsform einer flexiblen elektrischen Schaltung mit Verbindung zwischen elektrisch leitfähigen Strukturelementen,
Figur 4B eine dritte, verbesserte Ausführungsform einer flexiblen elektrischen Schaltung mit Verbindung zwischen elektrisch leitfähigen Strukturelementen,
Figur 5A eine Ausführungsform einer Sensoranordnung mit der zweiten Ausführungsform der flexiblen elektrischen Schaltung mit Verbindung zwischen elektrisch leitfähigen Strukturelementen, und
Figur 5B eine Ausführungsform einer Sensoranordnung mit der dritten Ausführungsform der flexiblen elektrischen Schaltung mit Verbindung zwischen elektrisch leitfähigen Strukturelementen.

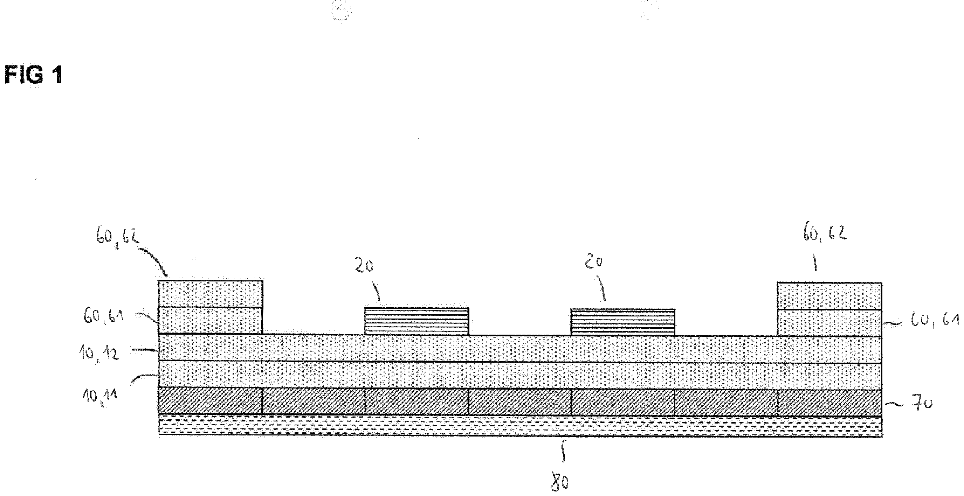

Die in Figur 1 gezeigte Schichtanordnung weist mindestens eine Lackschicht 10, beispielsweise aus einem UV-härtenden Polyurethan-Material, auf Die mindestens eine Lackschicht 10 kann beispielsweise die in Figur 1 gezeigten Lackschichten 11 und 12 umfassen. Auf einer Oberseite der mindestens einen Lackschicht 10, im dargestellten Ausführungsbeispiel der oberen Lackschicht 12, ist mindestens eine elektrische Leiterbahn 20 angeordnet. Im in Figur 1 dargestellten Ausführungsbeispiel der Schichtanordnung sind auf Bereichen der Oberseite der mindestens einen Lackschicht 10 zwei elektrische Leiterbahnen 20 angeordnet. Die Leiterbahnen 20 können als Kontaktflächen, die beispielsweise Carbon oder Silber (Silberpads) enthalten, ausgebildet sein.

Die mindestens eine elektrische Leiterbahn 20 ist im Bereich der dargestellten Verbindungsstelle nach oben frei zugänglich und nicht mehr von weiteren Lackschichten abgedeckt. Zur Erhöhung der Stabilität des Schichtaufbaus oder zur Isolation kann in weiteren Bereichen der Schichtanordnung mindestens eine weitere Lackschicht 60 vorgesehen sein. Teile der Leiterbahn 20, die entfernt von der Verbindungsstelle liegen, sind mit einer Lackschicht, beispielsweise der weiteren Lackschicht 60, abgedeckt. Im dargestellten Ausführungsbeispiel umfasst die mindestens eine weitere Lackschicht 60 zwei Lackschichten 61 und 62.

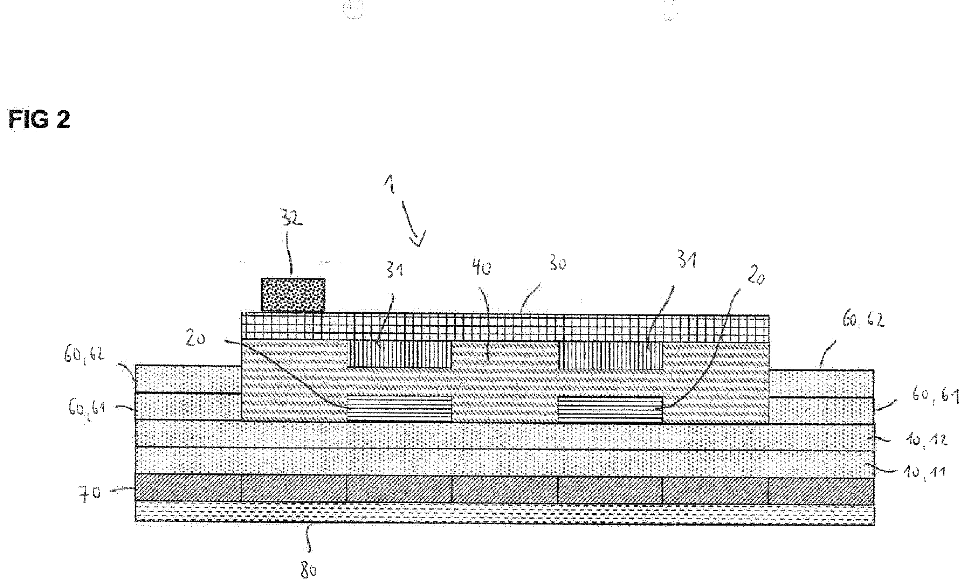

Bei der in Figur 2 dargestellten ersten Ausführungsform einer flexiblen elektrischen Schaltung 1 mit Verbindung zwischen elektrisch leitfähigen Strukturelementen ist im Vergleich zu der in Figur 1 dargestellten Schichtanordnung eine Trägerschicht 30, beispielsweise eine flexible Trägerfolie beziehungsweise flexible Leiterplatte oder eine starre Platine, über der mindestens einen Lackschicht 10 beziehungsweise den elektrischen Leiterbahnen 20 angeordnet. Auf der Trägerschicht 30 kann mindestens eine elektrische Komponente 32 und mindestens eine elektrisch leitende Kontaktschicht 31 zur Kontaktierung der mindestens einen elektrischen Komponente 32 angeordnet sein. Die mindestens eine elektrisch leitende Kontaktschicht 31 kann als eine Kontaktfläche ausgebildet sein, die zum Beispiel Gold enthält (Goldpad). Die Kontaktfläche 31 kann zum Beispiel eine Zusammensetzung aus Kupfer, Nickel und Gold aufweisen. Gemäß einer möglichen Ausführungsform kann die mindestens eine Kontaktschicht 31 als eine Silberschicht oder als eine Kupferschicht ausgebildet sein, die mit einer Gold- oder Zinn- oder Zinkschicht überzogen ist.

Zum Aufkleben der flexiblen elektrischen Schaltung auf einen Gegenstand, beispielsweise auf eine Verpackung, insbesondere eine Medikamentenverpackung, oder auf eine Platine zur Integration in eine weitere elektrische Schaltung, ist auf einer Unterseite der mindestens einen Lackschicht 10 eine Kleberschicht 70 angeordnet. Die Kleberschicht 70 ist bei dem in Figur 1 dargestellten Schaltungsaufbau unter der Lackschicht 11 angeordnet. Die Kleberschicht 70 ist von einer Schutzfolie 80 zum Schutz der Kleberschicht 70 abgedeckt. Die Schutzfolie 80 kann als eine abziehbare Folie (Abdeckliner) ausgebildet sein.

Zum Aufkleben der Trägerschicht 30 auf der mindestens einen Lackschicht 10 und den elektrischen Leiterbahnen 20 ist eine Leitkleberschicht 40 auf der Oberseite der mindestens einen Lackschicht 10 und auf der mindestens einen elektrischen Leiterbahn 20 angeordnet. Die Trägerschicht 30 haftet an ihrer Unterseite auf der Leitkleberschicht 40.

Für die Leitkleberschicht 40 kann in der dargestellten Ausführungsform ein anisotroper Leitkleber (ACP-Kleber) oder ein anisotrop leitender Kleberfilm (ACF Kleber) verwendet werden. Wenn die Leitkleberschicht 40 nur zwischen der elektrisch leitenden Kontaktschicht 31 und der elektrischen Leiterbahn 20 angeordnet ist, kann auch ein isotroper Leitkleber und möglicherweise ein Lötprozess eingesetzt werden. Der Kleber oder das Lot wird lokal, beispielsweise durch Dispensen, durch Siebdrucken oder durch Schablonendruck oder andere Auftragsverfahren, auf die elektrischen Leiterbahnen 20 aufgetragen. Dabei entsteht zwischen jeder der elektrischen Leiterbahnen 20, beispielsweise den Silberpads, und jeder der elektrisch leitenden Kontaktschichten 31, beispielsweise den Goldpads, eine elektrische und mechanische Verbindung.

Es hat sich allerdings herausgestellt, dass zwischen der mindestens einen Lackschicht 10 und der Trägerschicht 30 durch die Leitkleberschicht 40 nur eine geringe Haftung besteht.

Insbesondere bei Verwendung einer Leitkleberschicht 40 aus einem anisotropen Leitkleber ist zwar eine gute Haftung zwischen der elektrisch leitenden Kontaktschicht 31 und der elektrischen Leiterbahn 20 vorhanden. Allerdings besteht letztlich nur eine geringe Haftung zwischen der Trägerschicht 30 und der mindestens einen Lackschicht 10, da der Leitkleber 40 nur eine geringe Haftwirkung auf der mindestens einen Lackschicht 10 aufweist.

Bei Verwendung eines isotropen Klebers, der nur zwischen der elektrischen Leiterbahn 20 und der mindestens einen elektrisch leitenden Kontaktschicht 31 aufgetragen ist, kann sich eine weitere Schwachstelle in Bezug auf die Haftung zwischen der elektrischen Leiterbahn 20 und der mindestens einen Lackschicht 10 befinden.

Beim Einsatz eines isotropen Klebers besteht darüber hinaus aufgrund eines möglichen Fließens der Leitkleberschicht 40, die unter Druck- und Temperatureinwirkung aushärtet, die Gefahr von Kurzschlüssen zwischen benachbarten elektrisch leitfähigen Kontaktschichten 31 (Pads) der Trägerschicht 30.

Bei Verwendung einer anisotropen Leitkleberschicht kann die Haftung zwischen der Trägerschicht 30 und der mindestens einen Lackschicht 10 beziehungsweise der elektrischen Leiterbahn 20 nicht verbessert werden. Trotz Verwendung einer anisotropen Leitkleberschicht 40 aus verschiedenen Grundkomponenten, beispielsweise auf Polycarbaminsäurederivat-Basis oder auf Epoxy-Basis, besteht weiterhin nur eine geringe Haftung zwischen der Leitkleberschicht 40 und der mindestens einen Lackschicht 10. Dies kann insbesondere darauf zurückzuführen sein, dass sich in der mindestens einen Lackschicht 10 Silikonpartikel befinden, die sich an der Grenzfläche zu der Leitkleberschicht 40 befinden können, und dadurch die Haftung verringern.

Bei dem in Figur 2 gezeigten Aufbau einer flexiblen elektrischen Schaltung oder auch bei einer Ausführungsform, bei der auf die Trägerschicht 30 verzichtet wird und die mindestens eine elektrische Komponente 32 mit einer an ihrer Unterseite angebrachten mindestens einen elektrisch leitfähigen Kontaktschicht 31 unmittelbar auf der Leitkleberschicht 40 angeordnet ist, ergibt sich ein erhöhtes Risiko von Ausfällen während des Bestückungsprozesses, des Spendeprozesses und der späteren Verwendung der flexiblen elektrischen Schaltung. Dies ist darauf zurückzuführen, dass sich die Trägerschicht 30 mit der mindestens einen elektrischen Komponente 32 oder, im Falle der unmittelbaren Anordnung der mindestens einen elektrischen Komponente 32 auf der Leitkleberschicht 40, die mindestens eine elektrische Komponente 32 verhältnismäßig leicht von den darunterliegenden Schichten der Schaltungsanordnung, insbesondere der mindestens einen Lackschicht 10, ablösen kann.

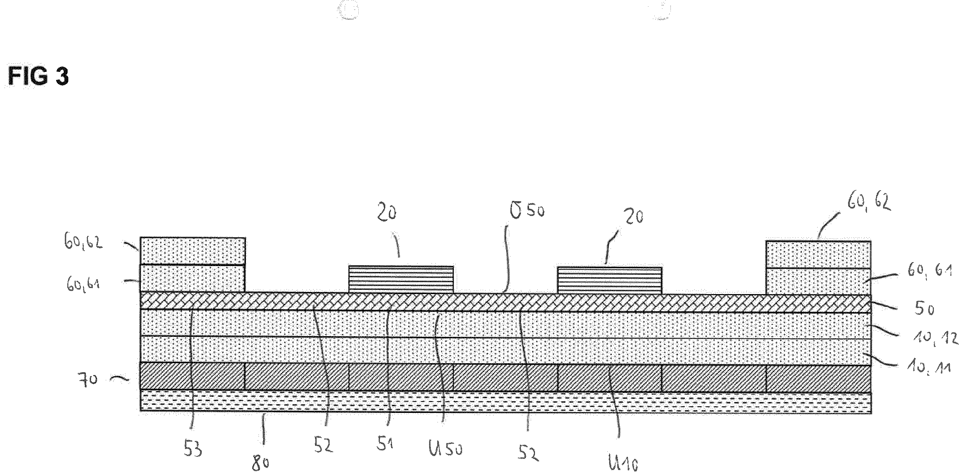

Figur 3 zeigt eine zweite, verbesserte Ausführungsform einer Schichtanordnung. Die Schichtanordnung umfasst mindestens eine Lackschicht 10 und mindestens eine elektrische Leiterbahn 20, die über der mindestens einen Lackschicht 10 angeordnet ist. Die mindestens eine Lackschicht 10 kann als ein Transferlack mit einer hohen mechanischen Stabilität ausgebildet sein. Die mindestens eine Lackschicht 10 ist bezüglich ihrer Eigenschaften reißfest, dehnbar und transferierbar ausgebildet.

Die mindestens eine Lackschicht kann eine Polymerschicht sein, die aus einer flüssigen Phase gedruckt wird. Die mindestens eine Lackschicht 10 kann zum Beispiel Polyurethane oder Latex/Kautschuk enthalten. Die mindestens eine Lackschicht 10 kann zum Beispiel ein UV aushärtendes Polyurethan enthalten. Gemäß einer möglichen Ausführungsform kann die mindestens eine Lackschicht eine Druckfarbe, ein Gießharz, eine Vergussmasse oder einen Klebstoff enthalten. Die mindestens eine Lackschicht 10 kann eine untere Lackschicht 11 und eine obere Lackschicht 12 aufweisen. Bei dem in Figur 3 gezeigten Schichtaufbau weist die mindestens eine elektrische Leiterbahn 20 zwei elektrische Leiterbahnen, die über der mindestens einen Lackschicht 10 angeordnet sind, auf. Die mindestens eine elektrische Leiterbahn 20 kann als eine elektrisch leitende Kontaktfläche ausgebildet sein, die zum Beispiel Carbon oder Silber (Silberpads) enthält.

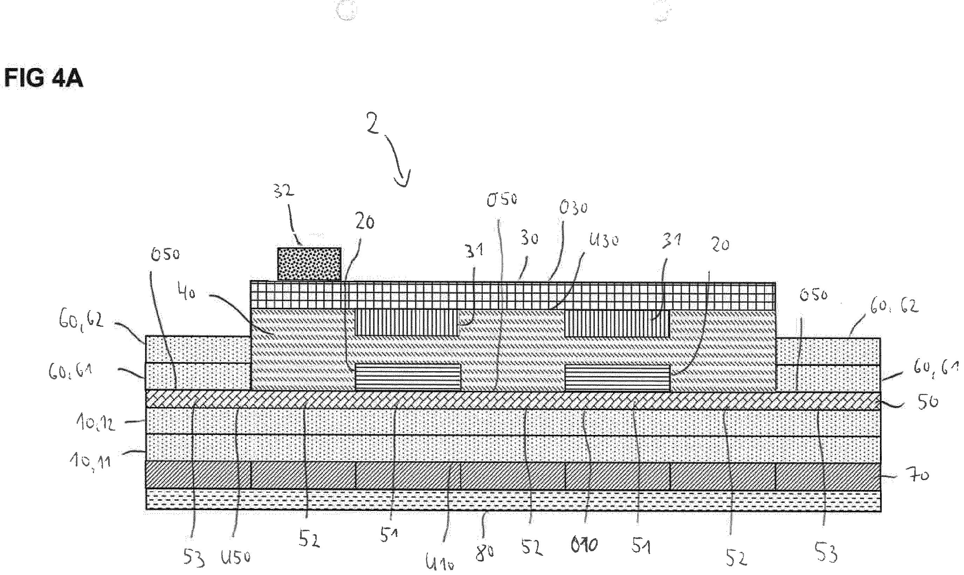

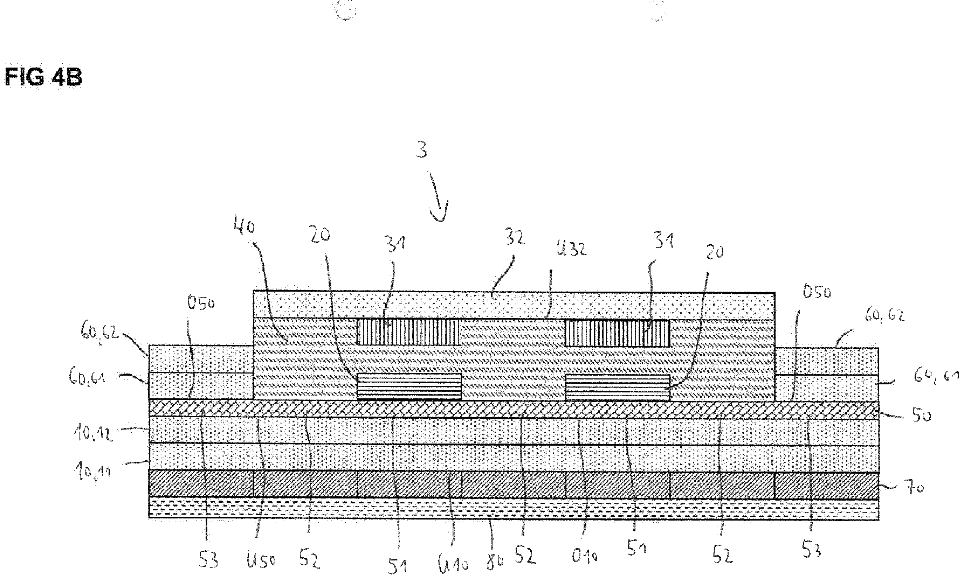

In Figur 4A ist eine zweite, verbesserte Ausführungsform einer flexiblen elektrischen Schaltung 2 mit Verbindung zwischen elektrisch leitfähigen Strukturelementen dargestellt. In Figur 4B ist eine dritte, verbesserte Ausführungsform einer flexiblen elektrischen Schaltung 3 mit Verbindung zwischen elektrisch leitfähigen Strukturelementen dargestellt. Die flexible elektrische Schaltung umfasst den in Figur 3 gezeigten Aufbau.

Die flexible elektrische Schaltung weist eine Kleberschicht 70 zum Aufkleben der Schaltung auf einen Gegenstand auf. Mittels der Kleberschicht 70 kann die flexible elektrische Schaltung beispielsweise in eine weitere elektrische Schaltung integriert werden, indem die flexible elektrische Schaltung mit Hilfe der Kleberschicht 70 auf eine Leiterplatte der weiteren elektrischen Schaltung aufgeklebt wird. Des Weiteren kann die flexible elektrische Schaltung zum Beispiel in eine Verpackung, beispielsweise eine Medikamentenverpackung, eingeklebt bzw. eingebaut werden. Die Kleberschicht 70 ist auf einer Unterseite U10 der mindestens einen Lackschicht 10 angeordnet. Zum Schutz der Kleberschicht 70 kann der Schaltungsaufbau eine Schutzfolie 80 aufweisen, die als eine abziehbare Folie (Abdeckliner) unter der Kleberschicht 70 angeordnet ist. Diese Folie ist beispielsweise elektrisch ableitend.

Im Unterschied zu der in den Figuren 1 und 2 gezeigten flexiblen elektrischen Schaltung umfasst die zweite und dritte Ausführungsform der flexiblen elektrischen Schaltung 2, 3 zusätzlich zu der Leitkleberschicht 40 eine Schicht 50 aus einem Haftvermittler. Die Schicht 50 aus dem Haftvermittler hat haftvermittelnde Eigenschaften und kann das Fließen des Leitklebers unter Temperatureinwirkung vermindern. Gemäß einer möglichen Ausführungsform kann die Haftvermittlerschicht einen lösemittelbasierten Acrylat-Lack aufweisen. Gemäß einer anderen Ausführungsform kann die Haftvermittlerschicht zum Beispiel ein polyolefinischer Haftvermittler oder ein Silanhaftvermittler sein. Für den Haftvermittler können des Weiteren metallorganische Haftvermittler, zum Beispiel Zirkonate und Titanate sowie Zirkon-Aluminate, eingesetzt werden. Die Schicht 50 aus dem Haftvermittler ist auf der mindestens einen Lackschicht 10 angeordnet.

Die Schicht 50 aus dem Haftvermittler ist unmittelbar auf der mindestens einen Lackschicht 10 angeordnet. Die Schicht 50 aus dem Haftvermittler ist dünner als die mindestens eine Lackschicht 10. Die Haftvermittlerschicht 50 kann beispielsweise eine Schichtdicke zwischen 1 µm und 15 µm aufweisen. Die mindestens eine Lackschicht 10 hat üblicherweise eine Schichtdicke zwischen 10 µm und 50 µm.

Die flexible elektrische Schaltung 2 umfasst des Weiteren mindestens eine elektrische Komponente 32. Die mindestens eine elektrische Komponente 32 kann ein passives oder aktives elektrisches Bauelement sein. Sie kann insbesondere ein Mikrokontroller, eine Batterie, ein Kommunikationschip, Diode oder eine Antenne sein.

Gemäß der in Figur 4A gezeigten Ausführungsform umfasst die flexible elektrische Schaltung 2 eine Trägerschicht 30, auf der die mindestens eine elektrische Komponente 32 angeordnet ist. Die mindestens eine elektrische Komponente 32 kann auf einer Oberseite O30 oder einer Unterseite U30 der Trägerschicht 30 angeordnet sein. Mindestens eine elektrisch leitende Kontaktschicht 31 zur Kontaktierung der mindestens einen elektrischen Komponente 32 ist an einer Unterseite U30 der Trägerschicht 30 angeordnet. Die Trägerschicht 30 ist auf der Leitkleberschicht 40 angeordnet. Die Trägerschicht 30 ist unmittelbar auf der Leitkleberschicht 40 angeordnet. Die Leitkleberschicht 40 ist zwischen der Trägerschicht 30 und der Schicht 50 aus dem Haftvermittler angeordnet. Die Leitkleberschicht 40 kann auf der Oberseite der Haftvermittlerschicht 50 beziehungsweise auf der Oberseite der Leiterbahn 20 oder auf der Unterseite der Trägerschicht 30 angeordnet sein. Die Trägerschicht 30 ist somit mittels der Leitkleberschicht 40 auf der Schicht 50 aus dem Haftvermittler aufgeklebt und haftet mittels des Haftvermittlers auf der mindestens einen Lackschicht 10. Des Weiteren ist auch die mindestens eine elektrisch leitende Kontaktschicht 31 auf der Leitkleberschicht 40 angeordnet.

Die Leitkleberschicht 40 als auch die Schicht 50 aus dem Haftvermittler dienen zur mechanischen Verbindung der Trägerschicht 30 mit der mindestens einen Lackschicht 10. Die Trägerschicht 30 kann eine elektronische Schaltung enthalten. Die Trägerschicht 30 kann insbesondere eine flexible Leiterplatte, eine flexible Folie oder eine starre Leiterplatte sein.

Gemäß der in Figur 4B gezeigten Ausführungsform der elektrischen Schaltung 3 ist die mindestens eine elektrische Komponente 32 unmittelbar auf der Leitkleberschicht 40 angeordnet. Im Vergleich zu der in Figur 4A gezeigten Ausführungsform ist die Trägerschicht 30 entfallen. Die Unterseite U32 der mindestens einen elektrischen Komponente 32 ist auf der Leitkleberschicht 40 angeordnet. Des Weiteren ist mindestens eine elektrisch leitende Kontaktschicht 31 zur Kontaktierung der elektrischen Komponente 32 an der Unterseite U32 der elektrischen Komponente 32 angeordnet. Die mindestens eine elektrisch leitende Kontaktschicht 31 ist auf der Leitkleberschicht 40 angeordnet. Die Leitkleberschicht 40 ist zwischen der mindestens einen elektrischen Komponente 32 und der Schicht 50 aus dem Haftvermittler angeordnet.

Durch das Vorsehen der Haftvermittlerschicht 50 auf der mindestens einen Lackschicht 10 haftet die mindestens eine elektrische Komponente 32 zuverlässig auf der mindestens einen Lackschicht 10. Im Vergleich zu einer Ausführungsform, bei der die Leitkleberschicht 40 unmittelbar auf der mindestens einen Lackschicht 10 angeordnet ist, ist die Haftung auch bei der in Figur 4B gezeigten Ausführungsform deutlich verbessert.

Zur elektrischen Verbindung der mindestens einen elektrischen Komponente 32 und der elektrischen Leiterbahn 20 ist bei den in den Figuren 4A und 4B gezeigten Ausführungsformen die Leitkleberschicht 40 zwischen der mindestens einen elektrisch leitfähigen Kontaktschicht 31 und der elektrischen Leiterbahn 20 angeordnet. Die Leitkleberschicht 40 ist unter der mindestens einen elektrisch leitenden Kontaktschicht 31 und über der Schicht 50 aus dem Haftvermittler angeordnet. Die Leitkleberschicht 40 ist zwischen der mindestens einen elektrisch leitenden Kontaktschicht 31 und der Schicht 50 aus dem Haftvermittler angeordnet.

Die mindestens eine elektrisch leitende Kontaktschicht 31 kann als eine Silberschicht oder als eine Kupferschicht ausgebildet sein, die mit einer Gold- oder Zinn- oder Zinkschicht überzogen ist. Insbesondere kann die mindestens eine elektrisch leitende Kontaktschicht 31 als eine Kupferschicht ausgebildet sein, die mit Nickel und Gold überzogen ist. Die mindestens eine elektrisch leitende Kontaktschicht 31 kann beispielsweise als eine vergoldete Kontaktfläche (Goldpad) an der Unterseite U30 der Trägerschicht 30 oder an der Unterseite der mindestens einen elektrischen Komponente 32 angeordnet sein.

Die Schicht 50 aus dem Haftvermittler kann selektiv oder vollständig auf der mindestens einen Lackschicht 10 angeordnet sein. Bei den in den Figuren 4A und 4B gezeigten Ausführungsformen der flexiblen elektrischen Schaltung 2 und 3 ist die Schicht 50 aus dem Haftvermittler vollflächig auf der mindestens einen Lackschicht 10 aufgetragen. Die Schicht 50 aus dem Haftvermittler ist insbesondere zwischen der mindestens einen Lackschicht 10 und der mindestens einen elektrischen Leiterbahn 20 angeordnet. Die elektrische Leiterbahn 20 ist somit unmittelbar auf der Haftvermittlerschicht 50 angeordnet.

Gemäß einer möglichen Ausführungsform kann die Haftvermittlerschicht 50 zumindest eine der Schichten 11 und 12 der mindestens einen Lackschicht 10 ersetzen. Es kann zum Beispiel ein Haftvermittler mit einem PU-Lack verwendet werden.

Die flexible elektrische Schaltung kann gemäß der in den Figuren 4A und 4B dargestellten Ausführungsform neben der mindestens einen Lackschicht 10 mindestens eine weitere Lackschicht 60 aufweisen. Die mindestens eine Lackschicht 60 ist auf einer Oberseite O50 der Schicht 50 aus dem Haftvermittler angeordnet. In den in den Figuren 4A und 4B dargestellten Ausführungsbeispielen weist die weitere Lackschicht 60 die Lackschichten 61 und 62 auf. Während die mindestens eine Lackschicht 10, insbesondere die Lackschicht 12 auf einer Unterseite U50 der Schicht 50 aus dem Haftvermittler angeordnet ist, sind die Lackschichten 61 und 62 übereinander auf der Schicht 50 aus dem Haftvermittler angeordnet. Die mindestens eine weitere Lackschicht 60 kann beispielsweise ein UV-aushärtbares Polyurethan oder 2K- oder lösemittelbasierende Materialien enthalten.

Die Schicht 50 aus dem Haftvermittler weist einen Bereich 51 und einen Bereich 52 auf. Der Bereich 52 ist beidseitig zu dem Bereich 51 angeordnet. Die elektrische Leiterbahn 20 ist auf der Oberseite O50 des Bereichs 51 der Haftvermittlerschicht 50 angeordnet. Die Leitkleberschicht 40 ist auf der Oberseite O50 des Bereichs 52 der Haftvermittlerschicht 50 angeordnet. Die Haftvermittlerschicht 50 weist darüber hinaus einen Bereich 53 auf. Der Bereich 53 ist neben dem Bereich 52 der Haftvermittlerschicht 50 angeordnet. Die mindestens eine weitere Lackschicht 60 ist auf der Oberseite O50 des Bereichs 53 der Schicht 50 aus dem Haftvermittler angeordnet.

Im Unterschied zu der in Figur 2 gezeigten Ausführungsform einer flexiblen elektrischen Schaltung 1 weisen die in den Figuren 4A und 4B gezeigten Ausführungsformen der flexiblen elektrischen Schaltung 2 und 3 eine hohe Haftkraft zwischen der Trägerschicht 30 (Figur 4A) beziehungsweise der mindestens einen elektrischen Komponente 32 (Figur 4B) und der mindestens einen Lackschicht 10 auf. Dies ist dadurch bedingt, dass der Leitkleber 40 nicht wie bei der in Figur 2 gezeigten Ausführungsform unmittelbar auf der mindestens einen Lackschicht 10 angeordnet ist. Stattdessen weisen die flexiblen elektrischen Schaltungen 2 und 3 der Figuren 4A und 4B die Haftvermittlerschicht 50 auf, die auf der Oberseite O10 der mindestens einen Lackschicht 10 angeordnet ist. Die Leitkleberschicht 40 haftet somit unmittelbar auf der Haftvermittlerschicht 50. Die Schicht 50 aus dem Haftvermittler haftet besser und stärker auf der mindestens einen Lackschicht 10 an als die Leitkleberschicht 40. Des Weiteren haftet die elektrische Leiterbahn 20 besser auf der Schicht 50 aus dem Haftvermittler als auf der Leitkleberschicht 40.

Durch die Verbindung zwischen der Haftvermittlerschicht 50 und der Leitkleberschicht 40 haftet die Trägerschicht 30 bei der in Figur 4A gezeigten Ausführungsform als auch die mindestens eine elektrische Komponente 32 bei der in Figur 4B gezeigten Ausführungsform somit zuverlässig auf der mindestens einen Lackschicht 10. Insbesondere tritt im Vergleich zu der in Figur 2 gezeigten Ausführungsform der flexiblen Schaltung eine hohe Haftkraft zwischen der Trägerschicht 30 beziehungsweise der mindestens einen elektrischen Komponente 32 und der mindestens einen Lackschicht 10 auf. Das ist insbesondere der Fall, wenn als Leitkleber 40 ein Snap cure Leitkleber verwendet wird.

Infolge der hohen Haftkräfte zwischen der Trägerschicht 30 beziehungsweise der mindestens einen elektrischen Komponente 32, dem Leitkleber 40, der Schicht 50 aus dem Haftvermittler und der mindestens einen Lackschicht 10 als auch durch die verbesserte Haftkraft zwischen der elektrischen Leiterbahn 20 und der Schicht 50 aus dem Haftvermittler zeichnet sich die flexible elektrische Schaltung durch eine geringe Ausfallrate unter der Einwirkung von mechanischen Einflüssen aus. Die Haftvermittlerschicht 50 weist eine mechanische und chemische Beständigkeit bei Temperaturen bis 200°C auf, sodass eine Haltbarkeit für mehrere Jahre gewährleistet ist.

Die mindestens eine Lackschicht 10, die elektrische Leiterbahn 20, die Leitkleberschicht 40 und die Haftvermittlerschicht 50 können durch ein Druckverfahren, beispielsweise durch Flexodruck, Inkjet-Druck oder Siebdruck, oder durch additive Verfahren, zum Beispiel Sprühen oder mittels Schlitzdüsen, übereinander aufgetragen werden. Bei Verwendung eines Siebdruckverfahrens kann die Anzahl der in den Figuren 3, 4A und 4B gezeigten Lagen der mindestens einen Lackschicht 10 als auch der mindestens einen Lackschicht 60 reduziert werden, indem beispielsweise gröbere Siebe verwendet werden oder ein Schablonendruck zum Einsatz kommt.

Zur Herstellung der flexiblen elektrischen Schaltungen 2, 3 können, wie bei der in Figur 2 gezeigten Ausführungsform, standardmäßig sechs Druckschritte verwendet werden, mit denen die einzelnen Schichten additiv auf einer silikonisierten Trägerfolie (Liner) aufgebracht werden. Zur Herstellung der in den Figur 4A und 4B gezeigten flexiblen elektrischen Schaltungen werden zunächst zwei Lack-Druckschritte zur Herstellung der Lackschichten 61 und 62, gefolgt von dem Drucken der elektrischen Leiterbahn 20 verwendet. Es folgen zwei weitere Lack-Druckschritte zur Herstellung der Lackschichten 11 und 12. Als letzter Druckschritt wird die Kleberschicht 70 aufgetragen. Im Unterschied zu der Herstellung der flexiblen elektrischen Schaltung gemäß Figur 2 wird zur Herstellung der in den Figuren 4A und 4B gezeigten Ausführungsformen 2 und 3 der flexiblen elektrischen Schaltung im Bereich der Leitklebestelle, wo mittels einer Thermode dann auch ausgehärtet werden muss, die Haftvermittlerschicht 50 hinzugefügt.

Bei der Herstellung der flexiblen elektrischen Schaltung können eine Thermode und gegebenenfalls eine Klebstoffraupe und/oder Klebstoffpunkte länger gewählt werden als der Bereich der elektrischen Leiterbahn 20 beziehungsweise der Bereich der mindestens einen elektrisch leitenden Kontaktschicht 31 (Bondpads) oder der Bereich 51 der Schicht aus dem Haftvermittler, sodass zusätzliche Klebefläche an den Rändern, das heißt in den Bereichen 52 der Haftvermittlerschicht 50 entsteht, wie dies in den Figuren 4A und 4B gezeigt ist.

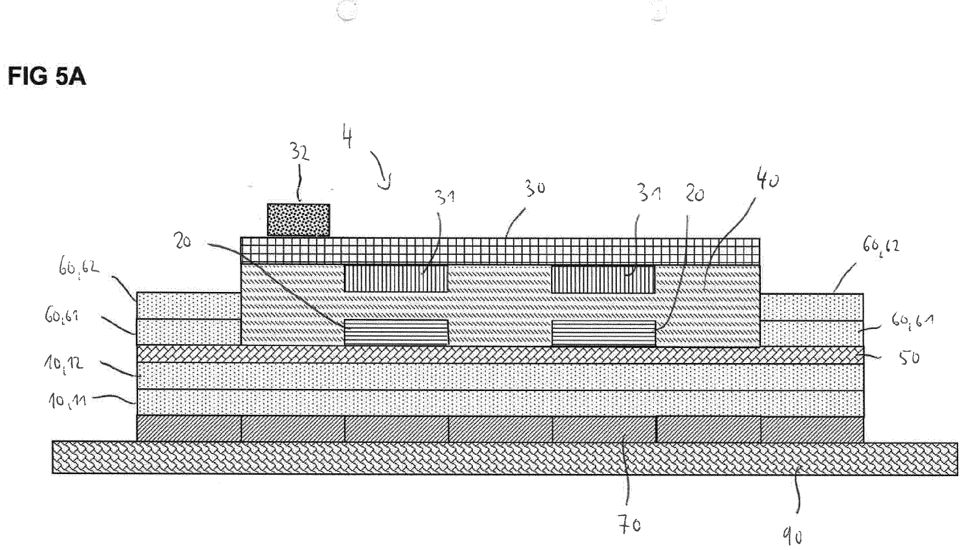

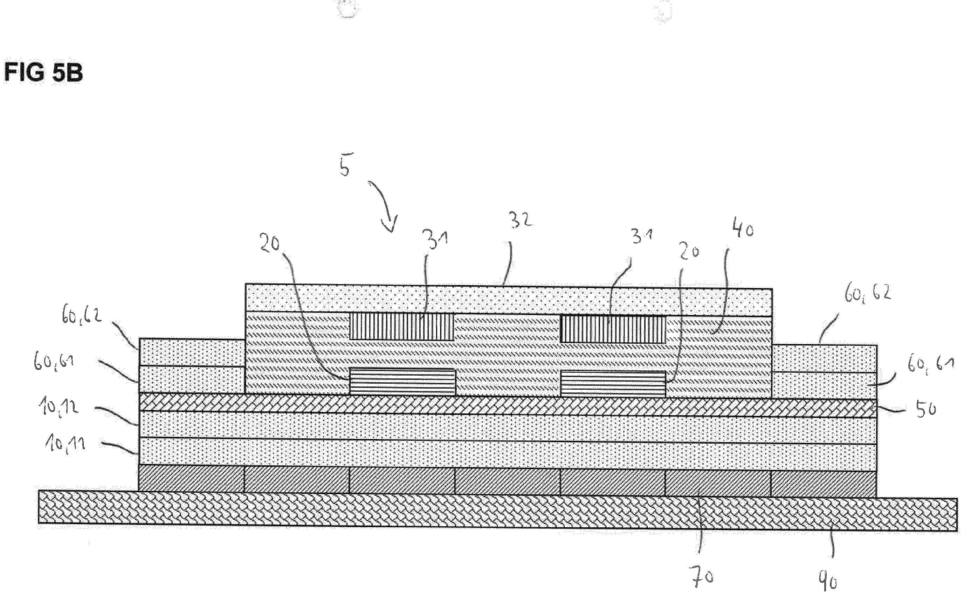

Die flexible elektrische Schaltung gemäß den Ausführungsformen 2 und 3 kann beispielsweise Teil einer Sensoranordnung 4, 5 sein. Figur 5A zeigt eine Sensoranordnung 4 mit der in Figur 4A gezeigten flexiblen elektrischen Schaltung 2, die mittels der Kleberschicht 70 auf ein Substrat 90 aufgeklebt ist. Figur 5B zeigt eine Sensoranordnung 5 mit der in Figur 4B gezeigten flexiblen elektrischen Schaltung 3, die mittels der Kleberschicht 70 auf ein Substrat 90 aufgeklebt ist. Das Substrat 90 kann eine Verpackung, beispielsweise eine Medikamentenverpackung sein. Die flexible elektrische Schaltung kann als ein Etikett mit elektrischer Funktionalität ausgebildet sein, das auf dem Substrat 90 angeordnet werden kann.

Die flexible elektrische Schaltung kann als Rollenware oder als Stückgut verarbeitet werden.

Die flexiblen elektrischen Schaltungen 2 oder 3 können insbesondere in eine Kartonage, in die ein Tablettenblister eingebracht und versiegelt wird, eingespendet werden. Die mindestens eine elektrische Komponente 32 kann insbesondere dazu ausgebildet sein, die Entnahme von Tabletten aus dem Blister beziehungsweise der Kartonage zu überwachen. Die mindestens eine elektrische Komponente 32 kann beispielsweise ein Mikrokontroller, ein Kommunikationschip, eine Antenne, eine Batterie beziehungsweise ein anderes elektrisches Bauelement sein.

### Bezugszeichenliste

- 1: erste Ausführungsform einer flexiblen elektrischen Schaltung
- 2: zweite, verbesserte Ausführungsform einer flexiblen elektrischen Schaltung
- 3: dritte, verbesserte Ausführungsform einer flexiblen elektrischen Schaltung
- 4,5: Sensoranordnung
- 10: Lackschicht
- 20: elektrische Leiterbahn
- 30: Trägersubstrat
- 31: elektrisch leitende Kontaktschicht
- 32: elektrische Komponente
- 40: Leitkleberschicht
- 50: Schicht aus einem Haftvermittler
- 60: weitere Lackschicht
- 70: Kleberschicht
- 80: Schutzfolie
- 90: Substrat

## Patentansprüche

1. Flexible elektrische Schaltung mit Verbindung zwischen elektrisch leitfähigen Strukturelementen, umfassend:
- mindestens eine Lackschicht (10),
- mindestens eine elektrische Leiterbahn (20), die über der mindestens einen Lackschicht (10) angeordnet ist,
- mindestens eine elektrische Komponente (32) und mindestens eine elektrisch leitende Kontaktschicht (31) zur Kontaktierung der elektrischen Komponente (32),
**gekennzeichnet durch**
- eine Leitkleberschicht (40) und eine Schicht (50) aus einem Haftvermittler,
- wobei die Schicht (50) aus dem Haftvermittler auf der mindestens einen Lackschicht (10) angeordnet ist,
- wobei die Leitkleberschicht (40) unter der mindestens einen elektrisch leitenden Kontaktschicht (31) und über der Schicht (50) aus dem Haftvermittler angeordnet ist.

2. Flexible elektrische Schaltung nach Anspruch 1,
wobei die Unterseite (U32) der mindestens einen elektrischen Komponente (32) auf der Leitkleberschicht (40) angeordnet ist.

3. Flexible elektrische Schaltung nach einem der Ansprüche 1 oder 2,
- wobei die mindestens eine elektrisch leitende Kontaktschicht (31) an der Unterseite (U32) der mindestens einen elektrischen Komponente (32) angeordnet ist,
- wobei die mindestens eine elektrisch leitende Kontaktschicht (31) auf der Leitkleberschicht (40) angeordnet ist.

4. Flexible elektrische Schaltung nach Anspruch 1, umfassend:
- eine Trägerschicht (30), auf der die mindestens eine elektrische Komponente (32) angeordnet ist,
- wobei die Trägerschicht (30) auf der Leitkleberschicht (40) angeordnet ist.

5. Flexible elektrische Schaltung nach Anspruch 4,
- wobei die mindestens eine elektrisch leitende Kontaktschicht (31) an einer Unterseite (U30) der Trägerschicht (30) angeordnet ist,
- wobei die mindestens eine elektrisch leitende Kontaktschicht (31) auf der Leitkleberschicht (40) angeordnet ist.

6. Flexible elektrische Schaltung nach einem der Ansprüche 1 bis 5,
wobei die Schicht (50) aus dem Haftvermittler zwischen der mindestens einen Lackschicht (10) und der elektrischen Leiterbahn (20) angeordnet ist.

7. Flexible elektrische Schaltung nach einem der Ansprüche 1 bis 6,
wobei die Leitkleberschicht (40) zur elektrischen Verbindung der mindestens einen elektrischen Komponente (32) und der elektrischen Leiterbahn (20) zwischen der mindestens einen elektrisch leitenden Kontaktschicht (31) und der elektrischen Leiterbahn (20) angeordnet ist.

8. Flexible elektrische Schaltung nach einem der Ansprüche 1 bis 7, umfassend:
- mindestens eine weitere Lackschicht (60), die auf einer Oberseite (O50) der Schicht (50) aus dem Haftvermittler angeordnet ist,
- wobei die mindestens eine Lackschicht (10) auf einer Unterseite (U50) der Schicht (50) aus dem Haftvermittler angeordnet ist.

9. Flexible elektrische Schaltung nach Anspruch 8,
- wobei die Schicht (50) aus dem Haftvermittler einen ersten Bereich (51) und einen zweiten Bereich (52) aufweist, wobei der zweite Bereich (52) beidseitig zu dem ersten Bereich (51) angeordnet ist,
- wobei die elektrische Leiterbahn (20) auf der Oberseite (O50) des ersten Bereichs (51) der Schicht (50) aus dem Haftvermittler angeordnet ist,
- wobei die Leitkleberschicht (40) auf der Oberseite (O50) des zweiten Bereichs (52) der Schicht (50) aus dem Haftvermittler angeordnet ist.

10. Flexible elektrische Schaltung nach Anspruch 9,
- wobei die Schicht (50) aus dem Haftvermittler einen dritten Bereich (53) aufweist, wobei der dritte Bereich (53) neben dem zweiten Bereich (52) der Schicht (50) aus dem Haftvermittler angeordnet ist,
- wobei die mindestens eine weitere Lackschicht (60) auf der Oberseite (O50) des dritten Bereichs (53) der Schicht (50) aus dem Haftvermittler angeordnet ist.

11. Flexible elektrische Schaltung nach einem der Ansprüche 1 bis 10,
- wobei die elektrische Leiterbahn (20) Silber oder Carbon enthält,
- wobei die mindestens eine elektrisch leitende Kontaktschicht (31) als eine Silberschicht oder als eine Kupferschicht ausgebildet ist, die mit einer Gold- oder Zinn- oder Zinkschicht überzogen ist,
- wobei die mindestens eine Lackschicht (10) Polyurethan enthält.

12. Flexible elektrische Schaltung nach einem der Ansprüche 1 bis 11, umfassend:
- eine Kleberschicht (70) zum Aufkleben der flexiblen elektrische Schaltung (1) auf ein Substrat (90),
- wobei die Kleberschicht (70) auf einer Unterseite (U10) der mindestens einen Lackschicht (10) angeordnet ist,
- wobei die Schicht (50) aus dem Haftvermittler auf einer Oberseite (O10) der mindestens einen Lackschicht (10) angeordnet ist.

13. Flexible elektrische Schaltung nach Anspruch 12, umfassend:
eine Schutzfolie (80), die zum Schutz der Kleberschicht (70) als eine abziehbare Folie unter der Kleberschicht (70) angeordnet ist.

14. Sensoranordnung, umfassend:
- eine flexible elektrische Schaltung (2, 3) nach Anspruch 12,
- ein Substrat (90),
- wobei die flexible elektrische Schaltung (2, 3) mittels der Kleberschicht (70) auf das Substrat (90) aufgeklebt ist.

15. Sensoranordnung nach Anspruch 14,
wobei das Substrat (90) eine Verpackung, insbesondere eine Medikamentenverpackung, ist.

## Claims

1. A flexible electrical circuit having connection between electrically conductive structure elements, comprising:
- at least one lacquer layer (10),
- at least one electrical conductor track (20) disposed above the at least one lacquer layer (10),
- at least one electrical component (32) and at least one electrically conductive contact layer (31) for contacting the at least one electrical component (32),
**characterized by**
- a conductive cement layer (40) and a primer layer (50),
- wherein the primer layer (50) is disposed on the at least one lacquer layer (10),
- wherein the conductive cement layer (40) is disposed underneath the at least one electrically conductive contact layer (31) and above the primer layer (50).

2. The flexible electrical circuit according to claim 1,
wherein an underside (U32) of the at least one electrical component (32) is disposed on the conductive cement layer (40).

3. The flexible electrical circuit according to one of claims 1 or 2,
- wherein the at least one electrically conductive contact layer (31) is disposed on the underside (U32) of the at least one electrical component (32), and
- wherein the at least one electrically conductive contact layer (31) is disposed on the conductive cement layer (40).

4. The flexible electrical circuit according to claim 1, comprising:
- a carrier layer (30) on which the at least one electrical component (32) is disposed,
- wherein the carrier layer (30) is disposed on the conductive cement layer (40).

5. The flexible electrical circuit according to claim 4,
- wherein the at least one electrically conductive contact layer (31) is disposed on an underside (U30) of the carrier layer (30),
- wherein the at least one electrically conductive contact layer (31) is disposed on the conductive cement layer (40).

6. The flexible electrical circuit according to one of the claims 1 to 5,
wherein the primer layer (50) is disposed between the at least one lacquer layer (10) and the at least one electrical conductor track (20).

7. The flexible electrical circuit according to one of the claims 1 to 6,
wherein the conductive cement layer (40), for electrical connection of the at least one electrical component (32) and the at least one electrical conductor track (20), is disposed between the at least one electrically conductive contact layer (31) and the at least one electrical conductor track (20).

8. The flexible electrical circuit according to one of the claims 1 to 7, comprising:
- at least one further lacquer layer (60) disposed on an upper side (O50) of the primer layer (50),
- wherein the at least one lacquer layer (10) is disposed on an underside (U50) of the primer layer (50).

9. The flexible electrical circuit according to claim 8,
- wherein the primer layer (50) has a first region (51) and a second region (52), wherein the second region (52) is disposed on both sides of the first region (51),
- wherein the at least one electrical conductor track (20) is disposed on an upper side (O50) of the first region (51) of the primer layer,
- wherein the conductive cement layer (40) is disposed on the upper side (O50) of the second region (52) of the primer layer (50).

10. The flexible electrical circuit according to claim 9,
- wherein the primer layer (50) has a third region (53), wherein the third region (53) is disposed next to the second region (52) of the primer layer,
- wherein the at least one further lacquer layer (60) is disposed on the upper side (O50) of the third region (53) of the primer layer (50).

11. The flexible electrical circuit according to one of the claims 1 to 10,
- wherein the at least one electrical conductor track (20) contains silver or carbon,
- wherein the at least one electrically conductive contact layer (31) is designed as a silver layer or as a copper layer, which is coated with a gold layer or a tin layer or a zinc layer,
- wherein the at least one lacquer layer (10) contains polyurethane.

12. The flexible electrical circuit according to one of the claims 1 to 11, comprising:
- an adhesive layer (70) for adhesive bonding of the flexible electrical circuit (1) on a substrate (90),
- wherein the adhesive layer (70) is disposed on an underside (U10) of the at least one lacquer layer (10),
- wherein the primer layer (50) is disposed on an upper side (O10) of the at least one lacquer layer (10).

13. The flexible electrical circuit according to claim 12, comprising:
a protective foil (80) disposed, for protection of the adhesive layer (70), as a peelable foil underneath the adhesive layer (70).

14. A sensor arrangement, comprising:
- a flexible electrical circuit (2, 3) according to claim 12,
- a substrate (90),
- wherein the flexible electrical circuit (2, 3) is adhesively bonded by the adhesive layer (70) on the substrate (90).

15. The sensor arrangement according to claim 14,
wherein the substrate (90) is a package, in particular a medicament package.

## Revendications

1. Circuit électrique flexible pourvu de raccordement entre des éléments structuraux électriquement conducteurs, comprenant :
- au moins une couche de vernis (10),
- au moins une piste conductrice électrique (20) qui est disposée au-dessus de l'au moins une couche de vernis (10),
- au moins un composant électrique (32) et au moins une couche de contact (31) électriquement conductrice pour la mise en contact du composant électrique (32),
**caractérisé par**
- une couche d'adhésif conducteur (40) et une couche (50) composée d'un agent d'adhérence,
- sachant que la couche (50) composée de l'agent d'adhérence est disposée sur l'au moins une couche de vernis (10),
- sachant que la couche d'adhésif conducteur (40) est disposée en-dessous de l'au moins une couche de contact (31) électriquement conductrice et au-dessus de la couche (50) composée de l'agent d'adhérence.

2. Circuit électrique flexible selon la revendication 1,
sachant que la face inférieure (U32) de l'au moins un composant électrique (32) est disposée sur la couche d'adhésif conducteur (40).

3. Circuit électrique flexible selon l'une des revendications 1 ou 2,
- sachant que l'au moins une couche de contact (31) électriquement conductrice est disposée sur la face inférieure (U32) de l'au moins un composant électrique (32),
- sachant que l'au moins une couche de contact (31) électriquement conductrice est disposée sur la couche d'adhésif conducteur (40).

4. Circuit électrique flexible selon la revendication 1, comprenant :
- une couche de support (30) sur laquelle l'au moins un composant électrique (32) est disposé,
- sachant que la couche de support (30) est disposée sur la couche d'adhésif conducteur (40).

5. Circuit électrique flexible selon la revendication 4,
- sachant que l'au moins une couche de contact (31) électriquement conductrice est disposée sur une face inférieure (U30) de la couche de support (30),
- sachant que l'au moins une couche de contact (31) électriquement conductrice est disposée sur la couche d'adhésif conducteur (40).

6. Circuit électrique flexible selon l'une des revendications 1 à 5,
sachant que la couche (50) composée de l'agent d'adhérence est disposée entre l'au moins une couche de vernis (10) et la piste conductrice électrique (20).

7. Circuit électrique flexible selon l'une des revendications 1 à 6,
sachant que la couche d'adhésif conducteur (40) destinée au raccordement électrique de l'au moins un composant électrique (32) et de la piste conductrice électrique (20) est disposée entre l'au moins une couche de contact (31) électriquement conductrice et la piste conductrice électrique (20).

8. Circuit électrique flexible selon l'une des revendications 1 à 7, comprenant :
- au moins une couche de vernis (60) supplémentaire qui est disposée sur une face supérieure (O50) de la couche (50) composée de l'agent d'adhérence,
- sachant que l'au moins une couche de vernis (10) est disposée sur une face inférieure (U50) de la couche (50) composée de l'agent d'adhérence.

9. Circuit électrique flexible selon la revendication 8,
- sachant que la couche (50) composée de l'agent d'adhérence présente une première zone (51) et une deuxième zone (52), sachant que la deuxième zone (52) est disposée des deux côtés par rapport à la première zone (51),
- sachant que la piste conductrice électrique (20) est disposée sur la face supérieure (O50) de la première zone (51) de la couche (50) composée de l'agent d'adhérence,
- sachant que la couche d'adhésif conducteur (40) est disposée sur la face supérieure (O50) de la deuxième zone (52) de la couche (50) composée de l'agent d'adhérence.

10. Circuit électrique flexible selon la revendication 9,
- sachant que la couche (50) composée de l'agent d'adhérence présente une troisième zone (53), sachant que la troisième zone (53) est disposée à côté de la deuxième zone (52) de la couche (50) composée de l'agent d'adhérence,
- sachant que l'au moins une couche de vernis (60) supplémentaire est disposée sur la face supérieure (O50) de la troisième zone (53) de la couche (50) composée de l'agent d'adhérence.

11. Circuit électrique flexible selon l'une des revendications 1 à 10,
- sachant que la piste conductrice électrique (20) contient de l'argent ou du carbone,
- sachant que l'au moins une couche de contact (31) électriquement conductrice est constituée comme couche d'argent ou comme couche de cuivre qui est revêtue d'une couche d'or ou d'étain ou de zinc,
- sachant que l'au moins une couche de vernis (10) contient du polyuréthane.

12. Circuit électrique flexible selon l'une des revendications 1 à 11, comprenant :
- une couche d'adhésif (70) destinée à coller le circuit électrique flexible (1) sur un substrat (90),
- sachant que la couche d'adhésif (70) est disposée sur une face inférieure (U10) de l'au moins une couche de vernis (10),
- sachant que la couche (50) composée de l'agent d'adhérence est disposée sur une face supérieure (O10) de l'au moins une couche de vernis (10).

13. Circuit électrique flexible selon la revendication 12, comprenant :
un film protecteur (80) qui est disposé comme film rétractable en-dessous de la couche d'adhésif (70) pour protéger la couche d'adhésif (70).

14. Agencement de capteur, comprenant :
- un circuit électrique flexible (2, 3) selon la revendication 12,
- un substrat (90),
- sachant que le circuit électrique flexible (2, 3) est collé sur le substrat (90) moyennant la couche d'adhésif (70).

15. Agencement de capteur selon la revendication 14,
sachant que le substrat (90) est un emballage, en particulier un emballage de médicament.
